# EUROPEAN PATENT APPLICATION

(11) **EP 1 431 825 A1**
(43) Date of publication of application: **23.06.2004**
(21) Application number: 02258833.9
(22) Date of filing: 20.12.2002
(51) Int. Cl.: G03F 7/20

(54) **Lithographic apparatus, device manufacturing method, and substrate holder**

(71) Applicant: ASML Netherlands B.V., 5503 LA Veldhoven (NL)
(72) Inventor: The designation of the inventor has not yet been filed
(74) Representative: Leeming, John Gerard

(57) **Abstract**

A substrate holder (10) has burls (12) having a height between 60 and 100 µm and at least 10 vacuum ports (13) arranged within a central region extending to a radius of two thirds the radius of the substrate. Thereby concave wafers can be reliably clamped by generating an initial vacuum in a central region which exerts a clamping force tending to flatten the wafer and allowing the initial vacuum to deepen until the wafer is fully clamped.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table having a substrate holder for holding a substrate, the substrate holder comprising a plurality of protrusions upstanding from a surface and having substantially coplanar extremities, a wall surrounding said protrusions and a plurality of vacuum ports opening into the space bounded by said wall; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to . Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

To hold the substrate to the substrate table, a so-called burl plate may be used. A burl plate described in EP-A-0 947 884 (which document is incorporated herein by reference) comprises a plate with a matrix arrangement of protrusions, or burls, on one face and a wall surrounding the matrix of burls. The burls all have a height of 150µm. Holes in the burl plate lead to a vacuum system whereby the space below the wafer can be evacuated. The pressure differential between the normal atmospheric pressure above the substrate and the evacuated region below clamps the substrate firmly to the burl plate. The vacuum ports are relatively numerous, *e.g.* 20 or more, and are disposed in two concentric rings.

Other known designs of substrate holder have a relatively small number of vacuum ports, *e.g*. 3 or 4. For example, US 5,923,408 discloses a substrate holder with three vacuum ports and protrusions that have total height of not less than 550µm - made up of a narrow section of diameter 100µm and height 50µm on top of a wider section of diameter not less than 1mm and a height not less than 500µm. US 5,324,012 discloses a pin chuck-type holder with a single vacuum port. The pin-type protrusions are said to have a height of from 10µm to 500µm but no specific examples are given. EP 1 077 393 A2 describes substrate holders that have one, four or eight vacuum ports and various arrangements of pin-like protrusions, but does not disclose the height of the pins.

The known designs of substrate holder suffer from the problem that if a concave (dished) substrate is placed on them it fails to be clamped because the wide gap between the raised edges of the substrate and the surrounding wall means that no vacuum develops underneath the substrate. Substrates can become concave due to processes carried out on them to build devices and must be discarded if they become too dished to be clamped onto the substrate table. The need to discard such substrates reduces yield and throughput.

It is an object of the present invention to provide a substrate holder that can more reliably clamp concave substrates.

This and other objects are achieved according to the invention in a lithographic apparatus as specified in the opening paragraph, characterized in that each of said protrusions has a height of not more than 100µm and there are 10 or more vacuum ports all of which open into a central region of said space bounded by said wall, said central region having a radius of not more than 70% of the radius of said substrate.

By reducing the height of the protrusions (which are also sometimes referred to as pimples or burls) and ensuring that a relatively large number of vacuum ports opens into a central region of the substrate holder, it is possible to ensure that a vacuum develops under the substrate even when the substrate is significantly concave. The pressure differential across the substrate tends to flatten the substrate enabling the initial vacuum to deepen, increasing the pressure differential and further flattening the substrate. It is therefore only necessary to develop an initial vacuum under the central region of the substrate to successfully clamp a substrate. The initial vacuum must be sufficient to have a flattening effect on the substrate but need not be as deep as the vacuum developed when the substrate is clamped. The necessary depth of the initial vacuum will depend on the mechanical properties and curvature of the substrates to be clamped. Once the substrate has been clamped it is flattened against the tops of the protrusions and the clamping effect is the same as if the substrate had been flat in the first place.

It is preferred that the protrusions have a height of no less than 60µm to ensure that the vacuum pressure under the substrate rapidly becomes uniform when the substrate is clamped. It is most preferred that the height of the protrusions is in the range of from 70 to 80µm. With protrusions of such a height, the inventors have discovered that silicon substrates of standard dimensions with a curvature of up to 800µm across a 300mm wafer can be successfully clamped.

Preferably, the number of vacuum ports is in the range of from 20 to 40, all of which open into the space within the central region. In a particularly preferred embodiment of the invention, all of the vacuum ports open into an annular region having an outer radius not more than 70% of the radius of the substrate (about 100mm for a 300mm substrate) and an inner radius of not less than 40% of the radius of the substrate (about 60mm for a 300mm substrate).

According to a further aspect of the invention there is provided a device manufacturing method comprising the steps of:
- providing a substrate that is at least partially covered by a layer of radiation-sensitive material;
- holding the substrate by evacuating the space between the substrate and a substrate holder, the substrate holder comprising a plurality of protrusions upstanding from a surface and having substantially coplanar extremities, a wall surrounding said protrusions and a plurality of vacuum ports opening into the space bounded by said wall;
- providing a projection beam of radiation using a radiation system;
- using patterning means to endow the projection beam with a pattern in its cross-section;
- projecting the patterned beam of radiation onto a target portion of the layer of radiation-sensitive material, characterized in that:

- each of said protrusions has a height of not more than 100µm and there are 10 or more vacuum ports all of which open into a central region of said space bounded by said wall, said central region having a radius of not more than 70% of the radius of said substrate.

According to yet a further aspect of the present invention, there is provided a substrate holder comprising a plurality of protrusions upstanding from a surface and having substantially coplanar extremities, a wall surrounding said protrusions and a plurality of vacuum ports opening into the space bounded by said wall; characterized in that:
each of said protrusions has a height of not more than 100µm and there are 10 or more vacuum ports all of which open into a central region of said space bounded by said wall, said central region having a radius of not more than 70% of the radius of said substrate.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 is a plan view of a substrate holder in the apparatus of Figure 1;
Figure 3 is a part sectional view of a substrate holder clamping a wafer W;
Figure 4 is a graph showing the vacuum pressure underneath the substrate in Figure 3;
Figure 5 is a part sectional view of a substrate holder in an initial stage of clamping a concave wafer; and
Figure 6 is a graph showing the vacuum pressure under the wafer in Figure 5.

In the Figures, corresponding reference symbols indicate corresponding parts.

### Embodiment 1

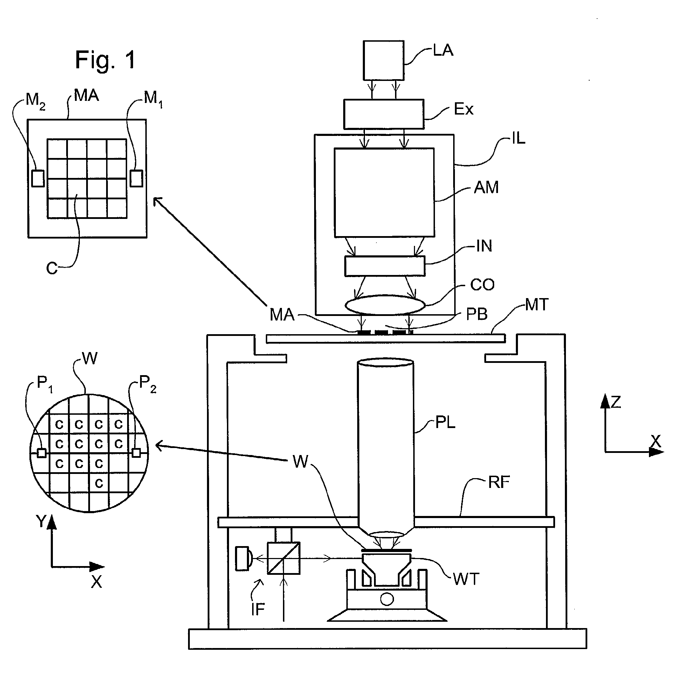

Figure 1 schematically depicts a lithographic projection apparatus according to a particular embodiment of the invention. The apparatus comprises:
a radiation system Ex, IL, for supplying a projection beam PB of radiation (*e*.*g*. DUV radiation), which in this particular case also comprises a radiation source LA;
a first object table (mask table) MT provided with a mask holder for holding a mask MA (*e*.*g*. a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* a refractive lens system) for imaging an irradiated portion of the mask MA onto a target portion C (*e.g*. comprising one or more dies) of the substrate W.
As here depicted, the apparatus is of a transmissive type (*e.g*. has a transmissive mask). However, in general, it may also be of a reflective type, for example (*e.g*. with a reflective mask). Alternatively, the apparatus may employ another kind of patterning means, such as a programmable mirror array of a type as referred to above.

The source LA (*e.g*. an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e*.*g*. so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

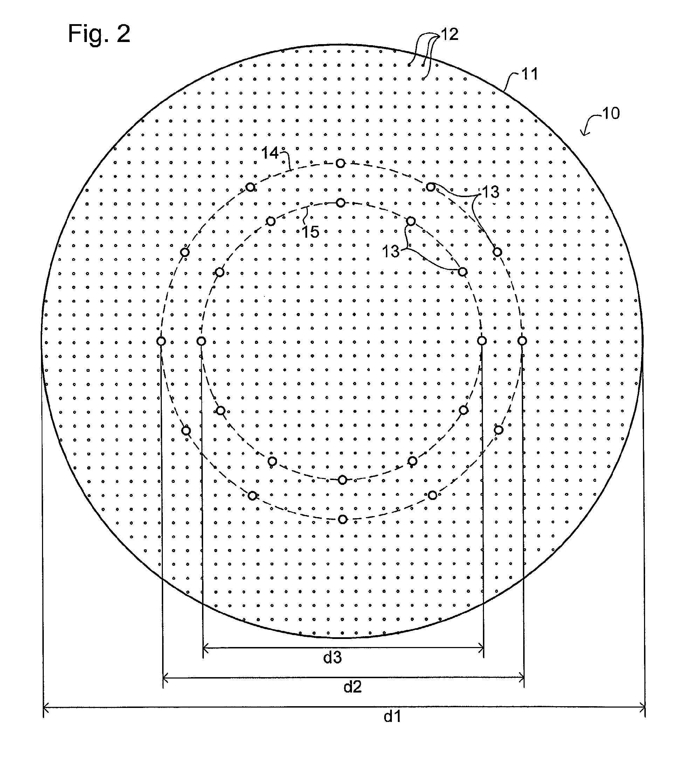

Figure 2 is a plan view of a substrate holder 10 which is positioned on the substrate table WT to hold a substrate thereon during exposures. The substrate holder 10 comprises a flat circular plate, the upper face of which is provided with an array of burls 12 and is bounded by a wall 11. The burls 12 support the substrate W and have a total area of usually less than about 4% of the area of the substrate. Whilst for illustrative purposes the burls 12 are shown as arrayed in a regular rectagonal matrix, other arrangements are possible, *e.g.* concentric rings.

The burl plate is also provided with through-holes 13, in this example there are 24 through-holes, arranged regularly around two concentric rings 14, 15. Through-holes 13 line up with vacuum ports on the substrate table WT and form vacuum ports for evacuation of the space below the substrate W and bounded by the wall 11.

The substrate W is removed from the substrate holder 10 by turning off the vacuum and lifting it from below by pins which extend through further holes (not shown) in the substrate holder 10. These further holes may be surrounded by walls that rise to meet the substrate so that there is no leakage of air into the space under the substrate via these holes.

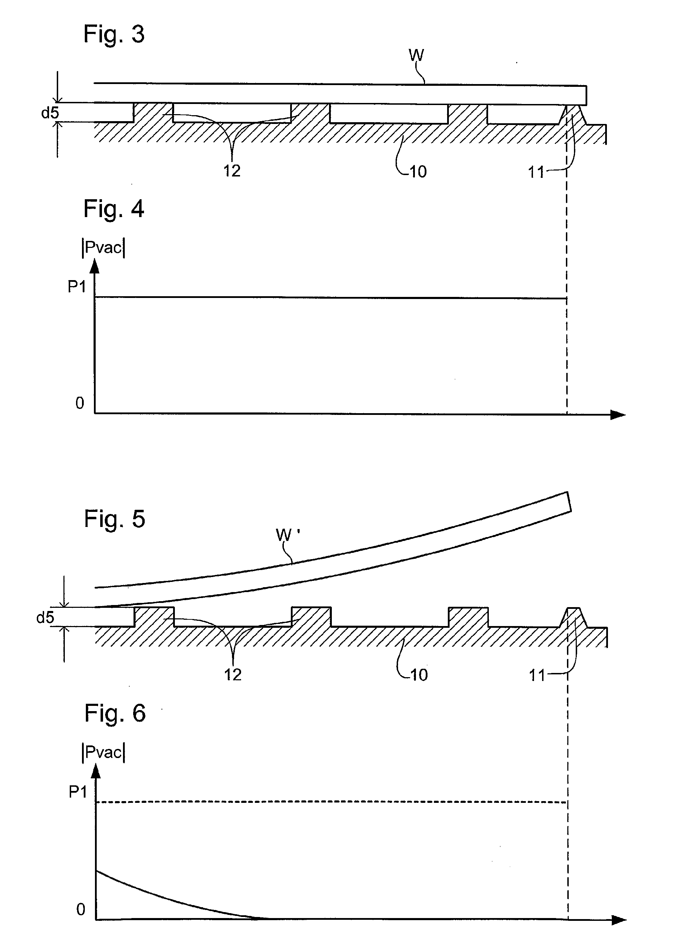

Figure 4 is a graph of vacuum pressure |Pvac|, that is the magnitude of the difference between the pressure in a space below the wafer and normal atmospheric pressure above. When a wafer is clamped correctly on the substrate table, the pressure underneath the wafer in the area within the wall 11 is at a uniform high vacuum level P1.

Figures 5 and 6 illustrate what happens when a concave wafer W' is presented to the substrate holder 10. At its outer edge, the curvature of the wafer W' means that there is a large gap between the wafer W' and the substrate holder 10 so that the pressure in this area is the same as above the wafer and there is no clamping effect. However, because according to the invention the heights of the projections 12 are reduced and the vacuum ports are arranged in a central region of the substrate holder 10, a vacuum does develop in the central region below the wafer W', as indicated by the solid curved line in Figure 6. There is therefore a pressure differential across the wafer causing a clamping force, albeit initially small, that clamps the wafer W' to the substrate holder 10 and also tends to flatten the substrate W'. The flattening of the substrate W' reduces the gap between it and the substrate holder 10 allowing the vacuum in the central region to deepen. This in turn increases the flattening force on the substrate W' and consequently the substrate W' is rapidly flattened and fully clamped to the substrate holder 10. The vacuum level underneath the substrate W' then reaches the normal level, as indicated by the dashed line in Figure 6.

The inventors have determined that certain conditions on the height of the projections 12 and the number and positioning of the vacuum ports 13 must be satisfied in order to enable concave substrates to be clamped. The height of the projections 12 should be sufficiently small so that there is some resistance to airflow inwards under a curved substrate W placed on the substrate holder 10 to allow an initial vacuum to develop underneath the central portion. At the same time however, the projections 12 should not be so short that the area of initial vacuum is confined too close to the vacuum ports 13 and a uniform vacuum level underneath the wafer cannot be obtained. The inventors have determined that to ensure clamping of curved wafers the projections 12 should have a height no more than 100µm. The height being measured from the surface representing most of the area of the substrate holder. Thereby the space below a substrate resting on the protrusions has a maximum depth of 100µm (excepting where the vacuum ports open). It may also be advantageous that the height is no less than 60µm to ensure the vacuum pressure under the substrate quickly becomes uniform when the wafer is fully clamped. Clamping is particularly effective if the burl height is in the range of from 70 to 80µm. A substrate holder 10 with projections having a height of 75µm was found to reliably clamp substrates where the maximum curvature was up to 800µm for a 300mm wafer.

For the number and arrangement of vacuum ports 13, it is necessary that they be sufficient in number and distributed sufficiently close to the center of the wafer to generate an initial vacuum. However, the vacuum ports should not be too far from the edge of the burl plate to ensure that the clamping process of concave wafers is initiated. The inventors have determined that there should be at least 10 vacuum ports within a central region. The central region is preferably bounded by a circle of radius less than or equal to 70% of the radius d1 of the substrate, *e.g.* 100mm for a 300mm (diameter) substrate. There should be no vacuum ports opening outside this central region. It is particularly preferred that the vacuum ports open into an annular region having an outer radius no more than 70% of the radius of the substrate and an inner radius no less than 40% of the radius of the substrate. In the described embodiment the vacuum ports are provided on rings 14, 15 having radii d2, d3 of 90mm and 70mm respectively.

Whilst specific embodiments of the invention have been described above, it will be appreciated that the invention may be practiced otherwise than as described. The description is not intended to limit the invention. For example, the substrate holder may by integrated into the substrate table rather than a separate plate. Also the invention may be applied to holders for reflective masks.

## Claims

1. A lithographic projection apparatus comprising:
- a radiation system for supplying a projection beam of radiation;
- a support structure for supporting patterning means, the patterning means serving to pattern the projection beam according to a desired pattern;
- a substrate table having a substrate holder for holding a substrate, the substrate holder comprising a plurality of protrusions upstanding from a surface and having substantially coplanar extremities, a wall surrounding said protrusions and a plurality of vacuum ports opening into the space bounded by said wall; and
- a projection system for projecting the patterned beam onto a target portion of the substrate; **characterized in that**:
- each of said protrusions has a height of not more than 100µm and there are 10 or more vacuum ports all of which open into a central region of said space bounded by said wall, said central region having a radius of not more than 70% of the radius of said substrate.

2. Apparatus according to claim 1 wherein the height of said protrusions is not less than 60µm.

3. Apparatus according to claim 2 wherein the height of said protrusions is in the range of from 70 to 80µm.

4. Apparatus according to claim 1, 2 or 3 wherein the number of said vacuum ports opening into said central region is in the range of from 20 to 40.

5. Apparatus according to claim 1, 2, 3 or 4 wherein all said vacuum ports open into an annular region having an outer radius no more than 70% of the radius of said substrate and an inner radius no less than 40% of the radius of said substrate.

6. A device manufacturing method comprising the steps of:
- providing a substrate that is at least partially covered by a layer of radiation-sensitive material;
- holding the substrate by evacuating the space between the substrate and a substrate holder, the substrate holder comprising a plurality of protrusions upstanding from a surface and having substantially coplanar to extremities, a wall surrounding said protrusions and a plurality of vacuum ports opening into the space bounded by said wall;
- providing a projection beam of radiation using a radiation system;
- using patterning means to endow the projection beam with a pattern in its cross-section;
- projecting the patterned beam of radiation onto a target portion of the layer of radiation-sensitive material, **characterized in that**
- each of said protrusions has a height of not more than 100µm and there are 10 or more vacuum ports all of which open into a central region of said space bounded by said wall, said central region having a radius of not more than 70% of the radius of said substrate.

7. A substrate holder comprising a plurality of protrusions upstanding from a surface and having substantially coplanar extremities, a wall surrounding said protrusions and a plurality of vacuum ports opening into the space bounded by said wall; **characterized in that**:
each of said protrusions has a height of not more than 100µm and there are 10 or more vacuum ports all of which open into a central region of said space bounded by said wall, said central region having a radius of not more than 70% of the radius of said substrate.
